# EUROPÄISCHE PATENTSCHRIFT

(11) **EP 2 273 678 B1**
(45) Veröffentlichungstag und Bekanntmachung des Hinweises auf die Patenterteilung: **24.10.2018**
(21) Anmeldenummer: 10010498.3
(22) Anmeldetag: 30.04.2002
(51) Int. Cl.: H03K 17/94, F24C 7/08

(54) **Gargerät mit Stelleinheit**
Cooking appliance with control device
Appareil de cuisson avec dispositif de commande

(30) Priorität: 07.07.2001 DE 10133135
(43) Veröffentlichungstag der Anmeldung: 12.01.2011
(62) Teilanmeldung aus: 02009715.0
(73) Patentinhaber: Electrolux Professional AG, 6210 Sursee (CH)
(72) Erfinder: Schütz, Friedrich, 4800 Zofingen (CH)
(74) Vertreter: Meissner Bolte Partnerschaft mbB

(56) Entgegenhaltungen:
- WO-A1-01/29483
- DE-A1- 2 855 935
- DE-A1- 10 026 058
- DE-A1- 19 645 907
- DE-A1- 19 842 545
- DE-A1- 19 903 300
- US-A- 4 121 204
- US-A- 4 204 204
- US-A- 4 386 347
- US-A- 5 559 301

## Beschreibung

Die Erfindung betrifft ein Gargerät mit wenigstens einer Stelleinheit.

Stelleinheiten von Haushaltsgargeräten sind üblicherweise als Drehsteller realisiert, mit denen beispielsweise die Heizleistung von Kochstellen stufenlos oder auch in Stufen einstellbar ist. Darüber hinaus sind Bedieneinheiten mit Tastaturen bekannt, die Drucktasten, Folientasten oder Berührungstasten aufweisen, um gewünschte Werte durch wiederholtes Betätigen einzustellen. So zeigen DE 198 17 195 C1 und der DE 298 11 628 U1 Kochfeld-Bedienbereiche, deren tastaturartig aufgebaute touch-control-Sensoren auf Siebensegment- oder Bargraphanzeigen wirken. Eingeformte Berührungstasten für Haushaltsgeräte offenbart die DE 295 19 714 U1.

In DE 196 45 907 A1 wird zum Einstellen eines Betriebszustandes eines Geräts, insbesondere eines Haushaltgeräts, aus einer vorgegebenen Anzahl von voneinander verschiedenen Betriebszuständen mit Hilfe von jeweils einem Betätigungssensor für jeden Betriebszustand ein gewünschter Betriebszustand nur dann eingestellt, wenn beginnend mit einem vorgegebenen Betätigungssensor als Startsensor nacheinander alle in wenigstens einer vorgegebenen Reihenfolge aufeinanderfolgenden Betätigungssensoren bis einschließlich einem dem gewünschten Betriebszustand zugeordneten Betätigungssensor als Zielsensor innerhalb jeweils einer vorgegebenen Betätigungszeit betätigt werden.

Während sich im Bereich der Drehsteller leicht Speisereste festsetzen oder von dort entlang der Drehachse in das Geräteinnere gelangen können, sind wiederholt zu betätigende Tastatursteller wenig bedienfreundlich.

Der Erfindung liegt daher die Aufgabe zugrunde, ein Gargerät mit wenigstens einer Stelleinheit zu schaffen, die geringe Verschmutzungsneigung mit hohem Bedienkomfort verbindet.

Erfindungsgemäß wird diese Aufgabe durch die Merkmale des Anspruchs 1 gelöst, wobei die davon abhängigen Ansprüche vorteilhafte Weiterbildungen zeigen.

Das Gargerät mit wenigstens einer Stelleinheit weist einen berührungsempfindlichen Stellstreifen auf, dessen Stellabschnitten Stellwerte oder Stellwertbereiche einer vorbestimmten Stellkurve zugeordnet sind.

Der Stellstreifen ist geradlinig ausgebildet. Den Stellabschnitten sind bevorzugt jeweils ein oder mehrere berührungsempfindliche Sensoren zugeordnet, die insbesondere kapazitiv, induktiv, optisch, thermisch, piezoelektrisch oder dgl. arbeiten und berührbare Plattenbereiche besitzen oder mit diesen zusammenwirken.

Dem Stellstreifen ist ein Anzeigestreifen zugeordnet, dessen Anzeigeabschnitte korrespondierenden Stellabschnitten des Stellstreifens zugeordnet sind. Die Anzeigeabschnitte weisen neben jeweils einer oder mehreren Lichtemitterdioden und gegebenenfalls einem oder mehreren Grafikdisplays (bzw. Bereichen von diesen) Plattenbereiche auf, die untereinander und mit den Plattenbereichen der Stellabschnittte verbunden sein können. Vorzugsweise besitzt jeder Anzeigeabschnitt oder jede vorbestimmte Gruppe von Anzeigeabschnitten eine andere Farbe.

Die Aktivierung der Anzeigeabschnitte folgt der Berührung der Stellabschnitte, wobei die Berührung eines Stellabschnittes zur Aktivierung eines von einem vorbestimmten Ende des Anzeigestreifens ausgehenden Bandes von Anzeigeabschnitten führt. Darüber hinaus bleibt die Aktivierung des oder der Anzeigeabschnitte des Anzeigestreifens bis zur nächsten Berührung des Stellstreifens erhalten.

Die Stellkurve verläuft von einem Minimalwert zu einem Maximalwert, wobei der Minimalwert insbesondere einem Auszustand des Haushaltsgerätes entspricht.

Gemäß einer besonderen Ausführungsform sind dem Stellstreifen ein oder mehrere zusätzliche Modi zugeordnet oder wahlweise zuordenbar, die vorzugsweise durch vorbestimmte Berührungsdauer wählbar und auf dem Anzeigestreifen anzeigbar sind und insbesondere ein oder mehrere durch Berührung aktivierbare Softkeys oder Zoom-Funktionen bereitstellen.

Der oder den Zoom-Funktionen sind vorzugsweise wenigstens ein Anzeigeabschnitt des Anzeigestreifens und/oder eine zusätzliche Zoom-Anzeige zugeordnet. Die Zoom-Einstellung geschieht durch abschnittsweises und/oder ein oder mehrmaliges Überstreichen des Stellstreifens.

Als Stellwerte kommen insbesondere Leistung, Temperatur, Druck, Feuchtigkeit, Umluft oder dgl. in Frage.

Die Plattenbereiche der Stell- und/oder Anzeigeabschnitte bilden ein Bedien- und/oder Anzeigefeld, das Teil einer Umhüllung des Haushaltsgerätes ist. Zumindest dieser Teil der Umhüllung ist dielektrisch. Auch ist zumindest der das Bedien- und/oder Anzeigefeld bildende Teil der Umhüllung plattenförmig und Teil einer Frontplatte eines Kochgerätes.

Die Stelleinheit ist kompromißlos hygienisch, läßt intuitive Bedienung zu und bietet unmittelbare optische Rückmeldung an.

Die Erfindung wird nachstehend anhand eines Ausführungsbeispiels näher erläutert. In den zugehörigen schematischen Zeichnungen zeigen:
Fig. 1 eine Stell- und Anzeigeeinheit in Draufsicht,
Fig. 2 die Stell- und Anzeigeeinheit im Soft-Key-Mode,
Fig. 3 die Stell- und Anzeigeeinheit im Zoom-Mode und

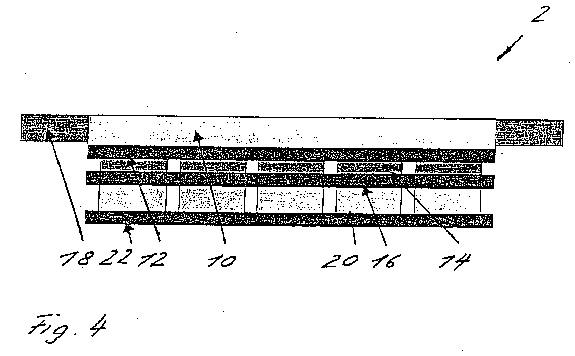

Fig. 4 die Stell- und Anzeigeeinheit in Seitenansicht.

Die Stell- und Anzeigeeinheit 2 eines nichtdargestellten Kochgerätes weist als Mensch-Maschine-Schnittstelle einen Stellstreifen 4 und einen Anzeigestreifen 6 auf, die ein Bedienfeld 8 bilden.

Der Stellstreifen 4 besteht von oben nach unten gesehen aus einer Abdeckung 10, einer Beschriftungsmaske 12 und einem metallische Sensorflächen 14 tragenden dielektrischen Träger 16. Die Abdeckung 10, beispielsweise eine Glasplatte, ist in einer Frontplatte 18 des Kochgerätes aufgenommen bzw. integriert. Die Beschriftungsmaske 12 ist als Keil ausgebildet, der den Anstieg von einem Minimalwert zu einem Maximalwert symbolisiert. Die vorzugsweise 16 Sensorflächen 14 sind in einer Linie angeordnet und bilden einen Sensorstreifen.

Der Anzeigestreifen 6 wiederum besteht von außen nach innen gesehen aus der Abdeckung 10 und einem Lichtemitterdioden 20 tragenden Träger 22, der auch den Träger 16 trägt. Während der Träger 22 vorzugsweise als Leiterplatte ausgebildet ist, besteht der Träger 16 aus einer Leiterfolie. Die vorzugsweise 16 Lichtemitterdioden bilden einen zum Sensorstreifen parallel verlaufenden Leuchtbalken, wobei jeder Sensorfläche 14 genau ein Stellwert und genau eine Lichtemitterdiode 20 zugeordnet ist, was andere festinstallierte oder (über eine nichtdargestellte Steuerung) wählbare Zuordnungen nicht ausschließt.

Die einzelnen Stellwerte bilden eine nichtdargestellte vorbestimmte Stellkurve, beispielsweise eine lineare oder logarithmische stellwegabhängige Leistungs- oder Temperaturkurve, die festinstalliert oder über die nichtdargestellte Steuerung automatisch oder wahlweise vorgebbar ist.

Im engeren Sinne kann auch die Einheit von Sensorstreifen und Leuchtbalken als Bedienfeld bezeichnet werden, das auf einer flexiblen dielektrischen Folie, einer starren dielektrischen Platte oder einer Kombination aus beidem basiert bzw. aufgebaut ist. Obwohl in verschiedenen Ebenen dargestellt, ließen sich beide Träger auch auf ein und derselben Ebene anordnen bzw. zu einem Träger verschmelzen. Um den Betriebszustand aus unterschiedlichen Blickwinkeln sichtbar zu machen, sind mit einem Sensorstreifen auch mehrere, an unterschiedlichen Gerätepositionen angeordnete Leuchtbalken ansteuerbar. Unterschiedliche Farbbereiche innerhalb des Leuchtbalkens dienen der besseren Assoziation des Stellwertes (z. B. rot für hohe Temperaturen). Die Abdeckung 10 kann aus Glas, Kunststoff, Stein oder anderem dielektrischen Material sein, bei piezo-technischen Sensoren auch aus elektrisch leitendem Material, vorzugsweise Chromnickelstahl. Sie sollte zwischen 0,1 und 10 mm dick sein, vorzugsweise 4 mm. Die vorzugsweise zwischen (transparenter) Abdeckung 10 und Bedienfeld (im engeren Sinne) eingefügten Beschriftungsmaske 12 trägt neben dem optischen Erscheinungsbild alle notwendigen Beschriftungen des Bedienfeldes.

Die Wirkungsweise ist folgende:
Berührt ein Finger F den Stellstreifen 4, bilden sich zwischen dem auf einem Bezugspotential liegenden Finger F und den gegenüberliegenden Sensorflächen 14 Kapazitäten aus, die einen auswertbaren Signalstrom bewirken, der (über die nichtdargestellte Steuereinheit) zur Ansteuerung der jeweils zugeordneten Lichtemitterdioden 20 und zur Aktivierung eines zugeordneten Stellwertes führt. Die Ansteuerung der Lichtemitterdioden ist auf verschiedene Weise möglich. In einem ersten Modus könnten immer gerade diejenigen Lichtemitterdioden leuchten, die den aktivierten Sensorflächen gegenüberliegen. Wandert der Finger F hin und her, wandert auch der durch die Lichtemitterdioden 20 gebildete Balkenbereich hin und her. Es ist aber auch ein Modus vorgesehen, bei dem nicht nur diejenigen Lichtemitterdioden 20 leuchten, die den aktivierten Sensorflächen 14 gegenüberliegen, sondern auch diejenigen, die sich bis zum Minimalwert am Ende des Leuchtbalkens erstrecken, so daß sich dessen Länge verändert.

Die Einstellung eines analogen Stellwertes erfolgt also durch Berühren des Sensorstreifens mit dem Finger, wobei z. B. das linke Ende dem kleinsten Wert oder Aus entspricht und das andere Ende dem Maximalwert. Die unmittelbare Rückmeldung erfolgt durch Aufleuchten des Leuchtbalkens vom kleinsten Wert bis zur Position, wo der Finger den Sensorstreifen berührt. Wird der Finger vom Sensorstreifen wieder weggenommen, so bleibt der Leuchtbalken stehen und dienst als relative Anzeige des eingestellten Wertes. Beim erneuten Berühren des Sensorstreifens an einer anderen Stelle paßt sich der Leuchtbalken unmittelbar an. Es besteht weiter die Möglichkeit, mit dem Finger auf dem Sensorstreifen langsam hin und her zu fahren, so daß der Leuchtbalken immer dem Finger folgt, und dabei iterativ den idealen Stellwert zu finden. Eine Streichbewegung über den Sensorstreifen bis hin zum tiefsten Wert oder über das Ende des Sensorstreifens hinaus führt zum Setzen des kleinsten Stellwertes oder zum Ausschalten des Gerätes. Umgekehrt führt ein Streichen mit dem Finger über den Sensorstreifen bis zum Maximalwert und eventuell über das Ende des Sensorstreifens hinaus zum Setzen des maximalen Stellwertes.

Statt kapazitiv arbeitender Sensoren können selbstverständlich auch induktiv, optisch, thermisch und piezoelektrisch arbeitende Sensoren verwendet werden, wobei insbesondere letztere neben dielektrischen auch metallische Abdeckungen zulassen.

Unabhängig davon lassen sich in der nichtdargestellten Steuereinheit Kommandos implementieren, die beispielsweise durch vorbestimmte Berührungszeiten des Stellstreifens auslösbar sind und vorbestimmte Modi (Kommunikations-Modi) zum Betreiben der Stelleinheit bereitstellen, wobei den einzelnen Sensoren oder Sensorengruppen neue Bedeutungen zugeordnet werden.

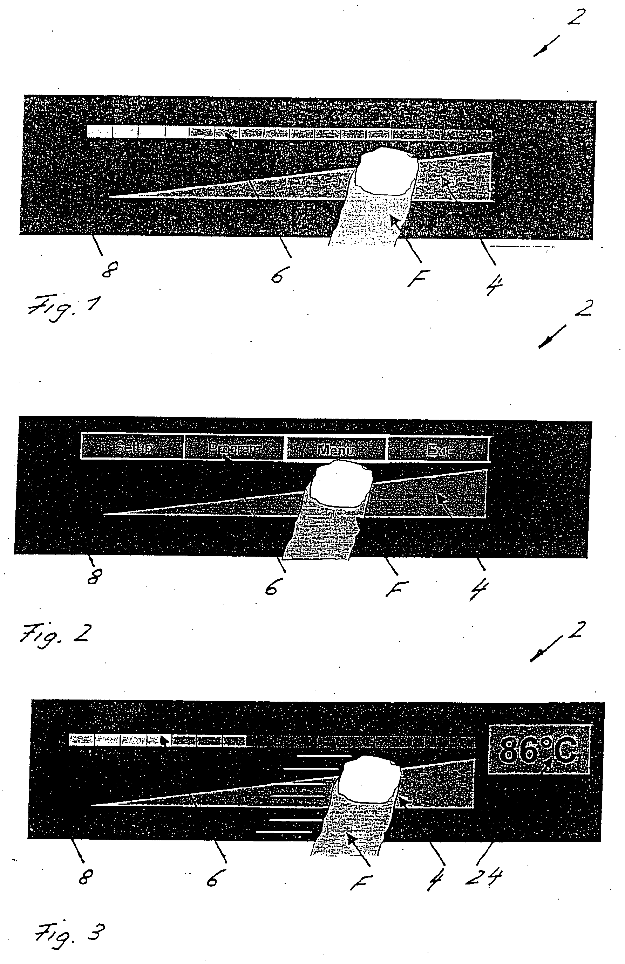

In einem ersten Modus gemäß Fig. 2, der beispielsweise nach einer Berührungszeit von 5 Sekunden zur Verfügung stehen kann, werden soft-keys gebildet, indem auf einem als Grafikdisplay ausgebildeten Anzeigestreifen über Texte oder Symbole Funktionen (Setup, Program, Menu, Exit) angezeigt werden, welche durch Berühren der darunterliegenden zugehörigen Sensoren oder Sensorengruppen des Stellstreifens aktivierbar sind.

In einem zweiten Modus gemäß Fig. 3, der beispielsweise nach 10 Sekunden Berührungszeit zur Verfügung steht, wird eine Zoom-Funktion gebildet, indem eine zusätzliche Digitalanzeige 24 aktiviert und einer Berührungsposition oder einem einmaligen vollständigen Überstreichen des Stellstreifens ein vorbestimmter Bruchteil (z. B. 10%) des ursprünglichen Stellwertes zugeordnet wird. Die Interpretation des Sensorstreifens wird also beispielsweise derart geändert, daß das einmalige Überstreichen des gesamten Sensorstreifens von links nach rechts oder umgekehrt nicht, wie normalerweise, eine Stellwertänderung vom Minimalwert zum Maximalwert oder umgekehrt bewirkt, sondern nur eine Erhöhung oder Reduktion des aktuellen Wertes um einen Bruchteil (z. B. 10 %). Das heißt, eine Veränderung des Stellwertes vom Minimalwert zum Maximalwert erfolgt durch mehrmaliges Überstreichen (z. B. 10 Mal) des gesamten Sensorstreifens in der entsprechenden Richtung. Der Leuchtbalken behält dabei seine ursprüngliche Funktion als Relativ-Anzeige zwischen Minimal- und Maximalwert.

In einem zweiten Modus gemäß Fig. 3, der beispielsweise nach 10 Sekunden Berührungszeit zur Verfügung steht, wird eine Zoom-Funktion gebildet, indem eine zusätzliche Digitalanzeige 24 aktiviert und einer Berührungsposition oder einem einmaligen vollständigen Überstreichen des Stellstreifens ein vorbestimmter Bruchteil (z. B. 10%) des ursprünglichen Stellwertes zugeordnet wird. Die Interpretation des Sensorstreifens wird also beipielsweise derart geändert, daß das einmalige Überstreichen des gesamten Sensorstreifens von links nach rechts oder umgekehrt nicht, wie normalerweise, eine Stellwertänderung vom Minimalwert zum Maximalwert oder umgekehrt bewirkt, sondern nur eine Erhöhung oder Reduktion des aktuellen Wertes um einen Bruchteil (z. B. 10 %). Das heißt, eine Veränderung des Stellwertes vom Minimalwert zum Maximalwert erfolgt durch mehrmaliges Überstreichen (z. B. 10 Mal) des gesamten Sensorstreifens in der entsprechenden Richtung. Der Leuchtbalken behält dabei seine ursprüngliche Funktion als Relativ-Anzeige zwischen Minimal- und Maximalwert.

## Patentansprüche

1. Gargerät mit wenigstens einer Stelleinheit (2) mit einem berührungsempfindlichen Stellstreifen (4), dessen Stellabschnitten Stellwertbereiche einer vorbestimmten Stellkurve zugeordnet sind,
wobei das Gargerät ein Kochgerät ist,
- bei dem der Stellstreifen (4) geradlinig verläuft,
- bei dem dem Stellstreifen (4) ein Anzeigestreifen (6) zugeordnet ist, dessen Anzeigeabschnitte korrespondierenden Stellabschnitten des Stellstreifens (4) zugeordnet sind und jeweils eine oder mehrere Lichtemitterdioden (20) aufweisen,
- bei dem die Aktivierung der Anzeigeabschnitte der Berührung der Stellabschnitte folgt,
- wobei die Berührung eines Stellabschnittes zur Aktivierung eines von einem vorbestimmten Ende des Anzeigestreifens ausgehenden Bandes von Anzeigeabschnitten führt und die Aktivierung des oder der Anzeigeabschnitte des Anzeigestreifens (6) bis zur nächsten Berührung des Stellstreifens (4) erhalten bleibt,
- bei dem die Anzeigeabschnitte Plattenbereiche aufweisen, die untereinander und mit den Plattenbereichen der Stellabschnitte verbunden sein können,
- bei dem die Plattenbereiche der Stell- und/oder Anzeigeabschnitte ein Bedien- und/oder Anzeigefeld (8) bilden, das Teil einer Umhüllung des Gargerätes ist,
- wobei zumindest der das Bedien- und/oder Anzeigefeld bildende Teil der Umhüllung dielektrisch und plattenförmig ist und Teil der Frontplatte (18) des Kochgerätes ist,
- wobei der Stellstreifen (4) von oben nach unten gesehen aus einer Abdeckung (10), einer Beschriftungsmaske (12), und einem metallische Sensorflächen (14) tragenden dielektrischen Träger (16) besteht,
- wobei die Abdeckung (10) eine Glasplatte ist und in der Frontplatte (18) des Gargerätes aufgenommen bzw. integriert ist,
- wobei die Sensorflächen (14) in einer Linie angeordnet sind und einen Sensorstreifen bilden,
- bei dem der Anzeigestreifen (6) aus der Abdeckung (10) und einem Lichtemitterdioden tragenden Träger (22) besteht, der auch den dielektrischen Träger (16) trägt,
- wobei der die Lichtemitterdioden (20) tragende Träger (22) als Leiterplatte ausgebildet ist und der dielektrische Träger (16) aus einer Leiterfolie besteht.

2. Gargerät nach Anspruch 1, bei dem die Stellabschnitte jeweils ein oder mehrere berührungsempfindliche Sensoren aufweisen, die insbesondere kapazitiv, induktiv, optisch, thermisch, piezoelektrisch oder dgl. arbeiten und berührbare Plattenbereiche aufweisen oder mit diesen zusammenwirken.

3. Gargerät nach Anspruch 2, bei dem jeder Anzeigeabschnitt oder jede vorbestimmte Gruppe von Anzeigeabschnitten eine andere Farbe aufweist.

4. Gargerät nach einem der Ansprüche 1 bis 3, bei dem die Stellkurve von einem Minimalwert, der insbesondere einem Auszustand des Haushaltsgerätes entspricht, zu einem Maximalwert verläuft.

5. Gargerät nach einem der Ansprüche 1 bis 4, bei dem dem Stellstreifen (4) ein oder mehrere zusätzliche Modi zugeordnet oder wahlweise zuordenbar sind, der oder die insbesondere durch vorbestimmte Berührungsdauer wählbar sind, wobei insbesondere
- der oder die Modi auf dem Anzeigestreifen (6) anzeigbar sind oder
- der oder die Modi ein oder mehrere durch Berührung aktivierbare Softkeys bereitstellen oder
- der oder die Modi eine oder mehrere Zoom-Funktionen bereitstellen, der oder denen insbesondere wenigstens ein Anzeigeabschnitt des Anzeigestreifens (6) oder eine zusätzliche Zoom-Anzeige (24) zugeordnet ist.

6. Gargerät nach Anspruch 5, bei dem die Zoom-Einstellung durch abschnittsweises und/oder ein oder mehrmaliges Überstreichen des Stellstreifens (4) erfolgt.

7. Gargerät nach einem der Ansprüche 1 bis 6, bei dem die Stellwerte Leistung, Temperatur, Druck, Feuchtigkeit, Umluft oder dgl. sind.

8. Gargerät nach einem der Ansprüche 1 bis 7, bei dem
- die Beschriftungsmaske als Keil ausgebildet ist, der den Anstieg von einem Minimalwert zu einem Maximalwert symbolisiert, oder
- die vorzugsweise 16 Sensorflächen in einer Linie angeordnet sind und einen Sensorstreifen bilden.

9. Gargerät nach einem der Ansprüche 1 bis 8, bei dem die vorzugsweise 16 Lichtemitterdioden einen zum Sensorstreifen parallel verlaufenden Leuchtbalken bilden, wobei insbesondere jeder Sensorfläche genau ein Stellwert und genau eine Lichtemitterdiode zugeordnet ist.

10. Gargerät nach einem der Ansprüche 1 bis 9, bei dem die einzelnen Stellwerte eine vorbestimmte Stellkurve bilden, beispielsweise eine lineare oder logarithmische stellwegabhängige Leistungs- oder Temperaturkurve, die fest installiert oder über die Steuerung automatisch oder wahlweise vorgebbar ist.

11. Gargerät nach Anspruch 10, bei dem dem Stellstreifen (4) ein oder mehrere, an unterschiedlichen Stellen angeordnete Anzeigestreifen (6) zugeordnet sind.

## Claims

1. A cooking appliance having at least one control unit (2) with a touch-sensitive control strip (4) whose setting sections are assigned to control point ranges of a predetermined control curve,
wherein the cooking appliance is a cooking device
- in which the control strip (4) extends in a straight line,
- in which the control strip (4) is associated with a display strip (6) whose display sections are associated with corresponding setting sections of the control strip (4), with each having one or more light-emitting diodes (20),
- in which the activation of the display sections follows the contacting of the setting sections,
- in which the contacting of a setting section results in the activation of a band of display sections emanating from a predetermined end of the display strip, and in which the activation of the display section or sections of the display strip (6) is maintained until the next contact with the control strip (4),
- in which the display sections have plate regions that can be connected to one another and to the plate regions of the setting sections,
- in which the plate regions of the setting and/or display sections form an control and/or display panel (8) that is part of a casing of the cooking appliance,
- in which at least the control and/or display panel that forms part of the casing is dielectric and plate-shaped and part of the front panel (18) of the cooking appliance,
- in which the control strip (4), when seen from top to bottom, consists of a cover (10), a labeling mask (12), and dielectric carrier (16) bearing metallic sensor surfaces (14),
- in which the cover (10) is a glass plate and incorporated or integrated into the front panel (18) of the cooking appliance,
- in which the sensor surfaces (14) are arranged in a line and form a sensor strip,
- in which the display strip (6) consists of the cover (10) and a carrier (22) bearing light-emitting diodes that also carries the dielectric carrier (16), and
- in which the carrier (22) bearing light-emitting diodes (20) is embodied as a printed circuit board and the dielectric carrier (16) consists of a conductive foil.

2. The cooking appliance as set forth in claim 1, wherein each of the setting sections has one or more touch-sensitive sensors which, in particular, operate capacitively, inductively, optically, thermally, piezoelectrically, or the like, and have touchable panel regions or interact therewith.

3. The cooking apparatus as set forth in claim 2, wherein each display section or each predetermined group of display sections is a different color.

4. The cooking appliance as set forth in any one of claims 1 to 3, wherein the control curve extends from a minimum value that corresponds particularly to an off state of the household appliance to a maximum value.

5. The cooking appliance as set forth in any one of claims 1 to 4, wherein one or more additional modes are or can be optionally assigned to the control strip (4) or can be selected particularly by means of a predetermined contact duration, particularly wherein
- the mode or modes can be displayed on the display strip (6) or
- the mode or modes provide one or more touch-activated softkeys or
- the mode or modes provide one or more zooming functions with which, in particular, one or more display sections of the display strip (6) or an additional zoom display (24) is associated.

6. The cooking appliance as set forth in claim 5, wherein the zoom is set by sweeping over the control strip (4) in a section-wise manner and/or once or multiple times.

7. The cooking appliance as set forth in any one of claims 1 to 6, wherein the control points are power, temperature, pressure, humidity, circulating air, or the like.

8. The cooking appliance as set forth in any one of claims 1 to 7, wherein
- the labeling mask is embodied as a wedge that symbolizes the increase from a minimum value to a maximum value, or
- the preferably 16 sensor surfaces are arranged in a line and form a sensor strip,

9. The cooking appliance as set forth in any one of claims 1 to 8, wherein the preferably 16 light-emitting diodes form a light bar that extends parallel to the sensor strip, with each sensor surface being particularly associated with exactly one control value and exactly one light-emitting diode.

10. The cooking appliance as set forth in any one of claims 1 to 9, wherein the individual control points form a predetermined control curve, such as a linear or logarithmic actuating path-dependent power or temperature curve, for example, that is permanently installed or can be automatically or selectively predetermined via the control system.

11. The cooking appliance as set forth in claim 10, wherein one or more display strips (6) arranged at different locations are associated with the control strip (4).

## Revendications

1. Appareil de cuisine comprenant au moins une unité de commande (2) munie d'un ruban de commande tactile (4) dont les sections de commande sont associées à des zones de valeurs de commande d'une courbe de commande prédéterminée,
l'appareil de cuisine étant un appareil de cuisson,
- dans lequel le ruban de commande (4) s'étend de manière rectiligne,
- dans lequel le ruban de commande (4) est associé à une ruban d'affichage (6) dont les sections d'affichage sont associées à des sections de commande correspondantes du ruban de commande (4) et comportent chacune au moins une diode électroluminescente (20),
- dans lequel l'activation des sections d'affichage suit le contact des sections de commande,
- le contact d'une section de commande entraînant l'activation d'une bande de sections d'affichage partant d'une extrémité prédéterminée du ruban d'affichage et l'activation de l'au moins une section d'affichage du ruban d'affichage (6) étant maintenue jusqu'au prochain contact du ruban de commande (4),
- dans lequel les sections d'affichage comportent des zones de plaque qui peuvent être reliées entre elles et aux zones de plaque des sections de commande,
- dans lequel les zones de plaque des sections de commande et/ou d'affichage forment un panneau de commande et/ou d'affichage (8) qui fait partie d'un boîtier de l'appareil de cuisson,
- au moins le panneau de commande et/ou d'affichage, qui fait partie du boîtier, étant diélectrique et en forme de plaque et faisant partie du panneau avant (18) de la cuisinière,
- dans lequel le ruban de commande (4) comprenant, de haut en bas, un couvercle (10), un masque de marquage (12) et un support diélectrique (16) portant des surfaces de détection métalliques (14),
- le couvercle (10) étant une plaque de verre et étant reçu ou intégré dans le panneau avant (18) de l'appareil de cuisine,
- les surfaces de détection (14) étant disposées suivant une ligne et formant un ruban de détection,
- dans lequel le ruban d'affichage (6) comprend le couvercle (10) et un support (22) portant des diodes électroluminescentes et portant également le support diélectrique (16), et
- le support (22) qui porte des diodes électroluminescentes (20) étant conçu sous la forme d'une carte de circuit imprimé et le support diélectrique (16) comprenant par un film conducteur.

2. Appareil de cuisine selon la revendication 1, dans lequel les sections de commande comportent chacune au moins un capteur tactiles qui fonctionne en particulier de manière capacitive, inductive, optique, thermique, piézoélectrique ou similaire, et qui comportent des zones de plaque tactiles ou coopèrent avec celles-ci.

3. Appareil de cuisine selon la revendication 2, dans lequel chaque section d'affichage ou chaque groupe prédéterminé de sections d'affichage est d'une couleur différente.

4. Appareil de cuisine selon l'une des revendications 1 à 3, dans lequel la courbe de commande s'étend d'une valeur minimale, correspondant notamment à un état d'arrêt de l'appareil ménager, à une valeur maximale.

5. Appareil de cuisine selon l'une des revendications 1 à 4, dans lequel le ruban de commande est associé ou au choix peut être associé à au moins un mode supplémentaire qui peut être choisi notamment par une durée de contact prédéterminée, en particulier
- l'au moins un mode pouvant être affiché sur le ruban d'affichage (6) ou
- l'au moins un mode offrant au moins une touche programmable activable par toucher ou
- l'au moins un mode offrant au moins une fonction de zoom à laquelle est associée notamment au moins une section d'affichage du ruban d'affichage (6) ou un affichage de zoom supplémentaire (24).

6. Appareil de cuisine selon la revendication 5, dans lequel l'on règle le zoom en balayant partiellement le ruban de commande (4) et/ou en le balayant une ou plusieurs fois.

7. Appareil de cuisine selon l'une des revendications 1 à 6, dans lequel les valeurs de commande sont la puissance, la température, la pression, l'humidité, la circulation d'air ou similaire.

8. Appareil de cuisine selon l'une des revendications 1 à 7, dans lequel
- le masque d'inscription se présente sous la forme d'un coin qui symbolise l'augmentation d'une valeur minimale à une valeur maximale, ou
- les surfaces de détection, de préférence au nombre de 16, sont disposées suivant une ligne et forment un ruban de détection.

9. Appareil de cuisine selon l'une des revendications 1 à 8, dans lequel les diodes électroluminescentes, de préférence au nombre de 16, forment une barre lumineuse qui s'étend parallèlement au ruban de détection, chaque surface de détection étant notamment associée à une seule valeur de commande et à une seule diode électroluminescente.

10. Appareil de cuisine selon l'une des revendications 1 à 9, dans lequel les valeurs de commande individuelles forment une courbe de commande prédéterminée, par exemple une courbe de puissance ou de température linéaire ou logarithmique fonction du trajet de commande, qui est installée de manière permanente ou qui peut être prédéterminée automatiquement ou sélectivement par le biais de la commande.

11. Appareil de cuisine selon la revendication 10, dans lequel au moins le ruban de commande (4) est associé à au moins un ruban d'affichage (6) disposées à différents endroits.
